# EUROPEAN PATENT APPLICATION

(11) **EP 2 455 219 A1**
(43) Date of publication of application: **23.05.2012**
(21) Application number: 10799469.1
(22) Date of filing: 03.05.2010
(51) Int. Cl.: B32B 5/08, B32B 38/04, G21F 1/12, E04B 1/92

(54) **ELECTROMAGNETIC-RADIATION-ATTENUATING LAMINAR MESH**

(30) Priority: 16.07.2009 ES 200930278 U
(71) Applicant: Hilatura Científica Atais, S.L., 46005 Valencia (ES)
(72) Inventor: PORTALES REIG, José Vicente, E-46116 Masias-Moncada (Valencia) (ES)
(74) Representative: Ungria Lopez, Javier
(86) International application number: PCT/ES2010/070285
(87) International publication number: WO 2011/007032

(57) **Abstract**

The present invention relates to a laminar mesh that attenuates electromagnetic radiation, designed to be preferably applied in buildings in order to protect certain architectural areas or parts against electromagnetic waves, **characterised in that** it is made by attaching to each other a textile mesh (1), natural or synthetic, and a strip of metallic or conducting material (2) to form a coating for the textile mesh (1).

## Description

### OBJECT OF THE INVENTION

The present invention, as described in the title of this specification, relates to a laminar mesh that attenuates electromagnetic radiation, preferably and mainly designed for use in construction work as a coating element to protect certain architectural parts where an attenuation of electromagnetic fields is desired.

### BACKGROUND OF THE INVENTION

Although aluminised sheets of tar or rock wool are known, in all cases these are conceived for heat and/or water insulation purposes, and are neither designed nor have the appropriate characteristics for attenuating electromagnetic radiation.

### DESCRIPTION OF THE INVENTION

The laminar mesh object of the invention constitutes what may be considered a mesh/grid that attenuates the effect of electromagnetic fields.

In this sense, the laminar mesh is basically formed by superimposing and attaching to each other of a textile structure in the form of a mesh made of a natural or synthetic material, and a coating of a metallic or conducting material, which can be applied on one of the sides of the base mesh or on both of its sides.

The mesh material is preferably polyethylene or polypropylene, forming a warp and weft of flat strips.

The coating can be applied on the mesh after it is formed or previously on the strip that will form this mesh. It can be applied in full or partially on one or both sides; in case of a partial coating, a grid-like coating is defined with strips of coated mesh crossing strips of uncoated mesh.

As a coating material it could be used, in addition to aluminium as the preferred material, other coating materials derived from aluminium with a thickness greater than 6 microns. Thus, the following may be used: solid or liquid aluminium oxide; aluminium halide; aluminosilicates; aluminium hydroxide; aluminium borohydride; aluminium salts; electrolysis of alumina.

In addition to aluminium-based components and all their combinations, in any state, it is also possible to use other components related to gold, platinum, silver, bromine, copper, zinc, tin, bronze and nickel, considering the use of any of these and their combinations in any state applied to an industrial process on the aforementioned textile mesh, for use in construction work, obtaining in all case a laminar mesh that attenuates and isolates electromagnetic fields in buildings.

As regards the method for attaching the coating of conducting material (aluminium) to the textile mesh (natural or synthetic), many different options are possible, such as: using an aerosol to form a layer on the mesh; submerging the mesh in liquid aluminium or corresponding chemical derivatives; using a prefabricated sheet bonded to the mesh; by electrolysis of alumina on the mesh; anodizing of the mesh; without ruling out other attachment systems or methods.

To ensure a correct adhesion of the polypropylene or polyethylene of the mesh and the metallic material coating, mechanical means such as punching may be used.

As an alternative, inducting polymers that can be intrinsic or extrinsic conductors may be used, understanding intrinsically conducting polymers as the synthetic polymers that can conduct an electrical current whose conductive properties depends on the intrinsic properties of the material or to modifications thereof. Intrinsically conducting polymers are those in which electrical conductivity arises from the extended conjugation of π electrons throughout the polymer chain. Examples of this more common type of polymers are poliacetylene, polypirrole, polithiophene and polianyline, which have carbon atoms in the main chain with sp² hybridisation. This hybridisation creates covalent bonds between the carbon atoms of the main chain and those of the branch chains. The sp² hybridisation leaves an unbonded p orbital, so that these orbitals overlap to form a π bond, with an arrangement of double bonds alternating with single carbon-carbon bonds along the chain.

Extrinsically polymers are those that owe their conductivity to the addition of conducting materials such as metals, graphite or a charge transfer complex to the polymer matrix, which is generally thermoplastic. In this case, in addition to the percolation concentration the conducting paths present along the material provide it with electronic conductivity, while the polymeric matrix allows processing the material in industrial operations to obtain different types of products and finishes.

### BRIEF DESCRIPTION OF THE DRAWINGS

To complete the description given below and in order to aid a better understanding of the characteristics of the invention, the present specification is accompanied by a set of drawings that help understand the innovations and advantages of the laminar mesh obtained according to the object of the invention.
Figure 1. Shows a plan view of a polyethylene textile mesh used to form the laminar mesh object of the invention, wherein the coating is applied to one of the sides of the mesh.
Figure 2. Shows a cross-sectional view of the laminar mesh of the invention, with the coating applied on one of the sides of the mesh.
Figure 3. Shows a cross-sectional view as that of the previous drawing, wherein the coating is applied to both sides of the mesh.

### DESCRIPTION OF THE PREFERRED EMBODIMENT

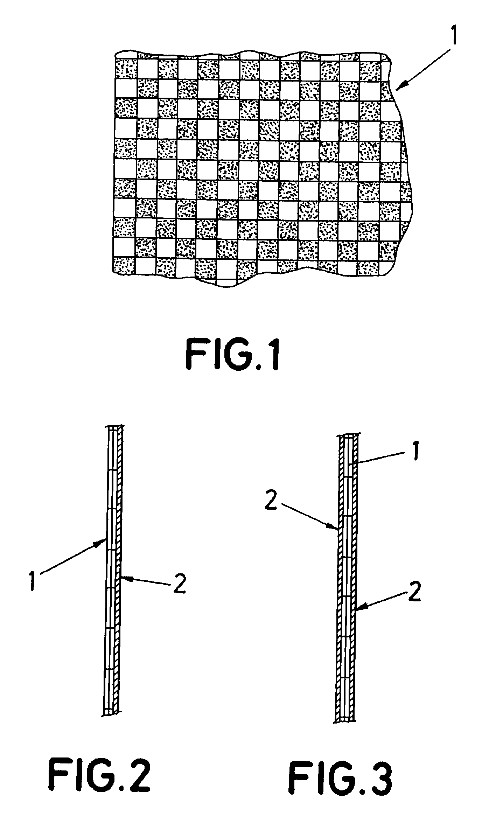

As shown in the drawings, the laminar mesh object of the invention is formed by a textile mesh 1 that can be natural or synthetic, and is preferably made of polyethylene or polypropylene, and a strip of metallic or conducting material 2, preferably made of aluminium and/or its derivatives or other appropriate conducting metals, forming a coating of the mesh thereof. The strip 2 constitutes a coating for one of the sides, as shown in figure 2, or for both sides, as shown in figure 3.

The two components (textile mesh 1 and metallic or conducting strip 2) can be attached to each other in many different ways. This is, any method can be used that allows depositing metal (particularly aluminium) particles on any spin or filament of a natural or synthetic material, either internally or externally, to obtain a final product in the form of a laminar mesh that protects and insulates against electromagnetic waves.

Alternatively, intrinsically or extrinsically conducting polymers can be used, as described in the previous section.

This allows obtaining a laminar mesh with a high mechanical strength and electromagnetic-field attenuation properties, preferably and mainly meant for use in construction work, and specifically to protect certain architectural parts or areas of buildings.

## Claims

1. Electromagnetic radiation attenuating laminar mesh, mainly designed for its use in buildings in order to protect certain architectural areas or parts against electromagnetic waves, **characterized in that** it is made by attaching to each other a textile mesh (1), natural or synthetic, and a strip of metallic or conducting material (2) to form a coating for the textile mesh (1).

2. Electromagnetic radiation attenuating laminar mesh, according to claim 1, **characterized in that** the textile mesh (1) is made of polyethylene.

3. Electromagnetic radiation attenuating laminar mesh, according to claim 1, **characterised in that** the textile mesh (1) is made of polypropylene.

4. Electromagnetic radiation attenuating laminar mesh, according to claim 1, **characterized in that** the coating strip of metallic or conducting material (2) is attached to a single face of the textile mesh (1).

5. Electromagnetic radiation attenuating laminar mesh, according to claim 1, **characterized in that** the coating strip of metallic or conducting material (2) is attached to both faces of the textile mesh (1).

6. Electromagnetic radiation attenuating laminar mesh, according to claim 1, **characterized in that** the coating strip of metallic material (2) is preferably made of aluminium or its derivatives.

7. Electromagnetic radiation attenuating laminar mesh, according to claim 1, **characterized in that** the coating strip of metallic material (2) is made of any conducting material, such as gold, silver, platinum, lead, copper, zinc, tin, bronze and nickel.

8. Electromagnetic radiation attenuating laminar mesh, according to any one of the above claims, **characterized in that the** coating (2) affects the entire surface of one or both faces of the textile mesh (1).

9. Electromagnetic radiation attenuating laminar mesh, according to any of claims 1 to 7, **characterized in that** the coating (2) partially affects one or both faces of the textile mesh (1).

10. Electromagnetic radiation attenuating laminar mesh, according to any one of the above claims, **characterized in that** the textile mesh (1) and the metallic coating material (2) are optionally attached to each other by punching.
